Europäisches Patentamt

European Patent Office

Office européen des brevets

(11) Publication number: **0 155 125**
A2

# EUROPEAN PATENT APPLICATION

(21) Application number: 85301402.5

(22) Date of filing: 28.02.85

(51) Int. Cl.⁴: **H 01 L 31/02, H 01 L 21/20**

(30) Priority: 05.03.84 US 586365

(43) Date of publication of application: 18.09.85
Bulletin 85/38

(84) Designated Contracting States: **BE CH DE FR GB IT LI
LU NL SE**

(71) Applicant: **ENERGY CONVERSION DEVICES, INC.,
1675 West Maple Road, Troy Michigan 48084 (US)**

(72) Inventor: **Nath, Prem, 245 Prospect, Rochester
Michigan 48063 (US)**
Inventor: **Izu, Masatsugu, 265 Manor Road, Birmingham
Michigan 48008 (US)**
Inventor: **Ovshinsky, Herbert C., 51200 Leslie, Oak Park
Michigan 48237 (US)**
Inventor: **Tennenhouse, Clifford, 1876 Boulan, Troy
Michigan 48084 (US)**
Inventor: **Young, James, 2193 Lawndale, West
Bloomfield Michigan 48044 (US)**

(74) Representative: **Jackson, Peter Arthur et al, GILL
JENNINGS & EVERY 53-64 Chancery Lane, London
WC2A 1HN (GB)**

(54) Level substrate for semiconducting devices and method for fabricating same.

(57) An improved semiconductor device includes a substrate (11) having a deposition surface, including at least one defect region (30, 32) capable of providing a low resistance shunt path or a nucleation centre, a relatively thick, continuous, electrically conductive leveling layer (26) electroplated on the deposition surface to provide a substantially defect-free surface, and a semiconductor body (27) deposited on the leveling layer. The substrate (11) is formed of aluminium or stainless steel while the leveling layer is preferably formed of nickel or silver.

0155125

ENERGY CONVERSION DEVICES, INC.      Ref: 50/2616/02

LEVEL SUBSTRATE FOR SEMICONDUCTING DEVICES
AND METHOD FOR FABRICATING SAME

Single crystal photovoltaic devices, especially crystalline silicon photovoltaic devices have been utilized for some time as sources of electrical power.  However, the utility of such devices is limited by problems associated with their manufacture.  More particularly, single crystal materials are difficult to produce in sizes substantially larger than several inches in diameter, are thicker and heavier than their amorphous counterparts and are expensive and time consuming to fabricate.

Unlike crystalline silicon which is limited to batch processing for the manufacture of solar cells, amorphous silicon alloys can be deposited in multiple layers over large-area substrates to form solar cells in a high volume, continuous processing apparatus.  In such apparatus, a substrate in the form of a continuous web may be continuously advanced through a succession of deposition chambers in each of which a specific semiconductor material is deposited.  In making an amorphous semiconductor photovoltaic device of p-i-n type configuration, the first chamber is dedicated for depositing a p-type semiconductor alloy, the second chamber is dedicated for depositing an intrinsic type amorphous semiconductor alloy, and the third chamber is dedicated for depositing an n-type semiconductor alloy.  The layers of semiconductor alloy material thus deposited in the vacuum envelope of the deposition apparatus may be utilized to form a photovoltaic device including one or more p-i-n cells, one or more n-i-p cells, a Schottky barrier, or the like.  Additionally, by making multiple passes of a continuous substrate web through the succession of deposition chambers, or by providing an additional array of deposition chambers, multiple stacked cells of various configurations may be deposited.

In the fabrication of thin film semiconductor material by the aforementioned deposition processes, the presence of current-shunting defects in the deposited films have been noted. Current-shunting defects cause photovoltaic devices to exhibit either a relatively low power output, since the collected electrical current flows through the defect region (the path of least resistance) in preference to an external load, or complete failure when sufficient current flows through the defect region to "burn out" the device. Current-shunting defects may be "patent" or latent and not immediately manifested. Latent defects can produce an "operational mode failure" in a photovoltaic device, initially exhibiting satisfactory electrical performance, but siddenly failing.

In an amorphous semiconductor p-i-n photovoltaic device, a typical p-type layer may be only on the order of 40 nanometers thick, a typical intrinsic type layer may be only be on the order of 350 nanometers thick, and a typical n-type layer may be only on the order of 20 nanometers thick, for a total single device thickness of only about 410 nanometers. Therefore substrate defects, i.e., surface irregularities, however small, can adversely affect the quality of the thin film of deposited semiconductor material. In fact, it has now been ascertained that current-shunting defects, both latent and patent, arise from surface defects or irregularities in the morphology of the deposition surface of the substrate material.

The highest quality stainless steel previously used as a substrate for amorphous silicon has been estimated to contain 10,000 to 100,000 surface defects, i.e., irregularities, per square centimeter. Such irregularities take the form of projections, craters, or other deviations from a smooth finish, and may be greater than a micron in depth below the surface, height above the surface, or in diameter. A spike projecting from the surface of the substrate may be too tall to be covered by the deposited layers of semiconductor material, and, therefore, be in direct electrical contact with a second electrode that it is deposited on the semiconductor material. A crater in the surface of the substrate may be of too large a diameter or too large a depth to be filled by deposited layers of semiconductor material. When a second electrode is deposited on the semiconductor material it may be directly connected to the substrate at the crater edge or in use the electrode material may migrate toward and contact the other electrode. Even if a defect is not large, sharp or jagged features may form nucleation centers that promote non-homogeneous growth of the deposited semiconductor material.

The previous difficulties resulting from surface defects on substrates are solved in the present invention by electroplating a continuous, relatively thick, electrically conductive "leveling layer" is on the surface of the substrate on which a body of semiconductor material is to be deposited. This leveling layer provides a smooth, substantially defect-free deposition surface for the semiconductor material. A coating of an optically matched material is preferably applied to leveling layer to produce a back reflector compatible (defined here as being optically and adhesively matched) with the subsequently deposited amorphous silicon alloy semiconductor material.

Figure 1 is a fragmentary, cross-sectional view of a photovoltaic device including a plurality of p-i-n cells.

Figure 2 is an exploded, perspective view of an improved semiconductor device depicting a leveling layer according to the invention.

Figure 3A is a cross-sectional view illustrating surface defects formed in the substrate of a p-i-n type semiconductor device which does not incorporate an embodiment of the invention.

Figure 3B is a cross-sectional view of a semiconductor device illustrating a leveling layer according to the instant invention, including a comptaibility layer, operatively disposed on the deposition surface of the substrate.

Figure 4 is a schematic illustration of an embodiment of the nickel alloy plating bath employed to deposit a leveling layer continuously according to the invention.

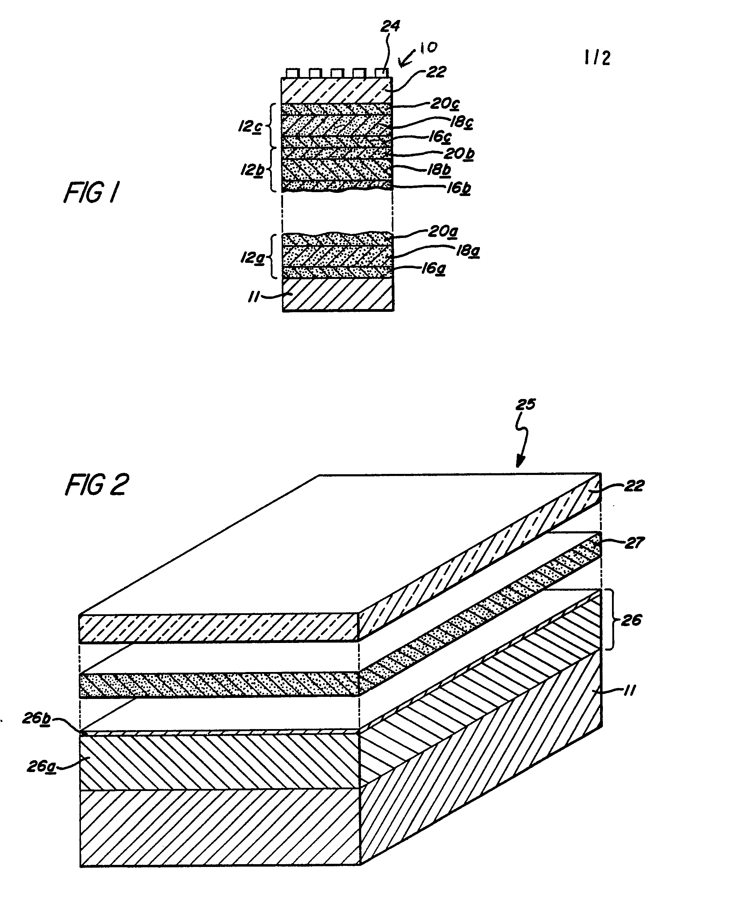

In Figure 1, a photovoltaic cell 10 formed of a plurality of successively deposited layers of a semiconductor alloy is shown. Cell 10 is typical of the type of photovoltaic cell in which the invention may be incorporated. Cell 10 is composed of individual cells 12a, 12b and 12c. Substrate 11 adjacent cell 12a is an electrode that may be transparent or formed from an opaque metallic material such as stainless steel, mild steel, aluminum, tantalum, molydenum or chromium. The term "substrate" includes not only a flexible film, but also any elements deposited on the film by preliminary processing.

Each of cells 12a, 12b and 12c contain layers of at least a silicon or germanium alloy including an n-type conductivity semiconductor layer 20a, 20b and 20c; an intrinsic semiconductor layer 18a, 18b and 18c; and a p-type conductivity semiconductor layer 16a, 16b and 16c. As illustrated, cell 12b is an intermediate cell and, as indicated in Figure 1, additional intermediate cells may be stacked on the illustrated cells without departing from the spirit or scope of the present invention.

A TCO (transparent conductive oxide) layer 22, formed in the preferred embodiment of indium tin oxide, is deposited on cell 12c as a second electrode. An electrode grid 24 applied to TCO layer 22 shortens the carrier path through the TCO and increases the current collection efficiency.

In the description and claims that follow, the layer or layers of semiconductor material disposed between substrate 11 and second electrode 22 are referred to as the "semiconductor body", which includes combinations of semiconductor layers of various conductivities and materials which will provide for a flow of electrical current when appropriately combined with one or more electrodes.

In Figure 2 a photovoltaic device 25 embodying the invention is shown. Photovoltaic device 25 includes an electrically conductive substrate 11 forming one electrode of device 25. In the preferred embodiments of the invention, substrate 11 is formed of stainless steel or aluminum with a leveling layer 26 deposited upon the deposition surface of the substrate. Leveling layer 26 preferably includes a relatively thick nickel alloy substratum 26a and a relatively thin alloyed superstratum 26b. The nickel alloy substratum performs the substrate leveling function of the invention, while the thin alloy superstratum provides for both semiconductor material adhesion and optical matching. Disposed on leveling layer 26 is a body of semiconductor material 27 that may include either a single layer or multiple layers of semiconductor material. A second electrode 22 is deposited on semiconductor body 27. Electrode 22 is preferably formed of indium tin oxide for transparency, electrical conductivity and low resistivity.

Leveling layer 26a is deposited by an electroplating procedure to provide a deposition surface characterized by a substantially reduced number of surface irregularities for the subsequent deposition of body 27. The relatively thick leveling layer substantially decreases the effect of current-shunting defect regions by preventing nucleation of defect sites and promoting homogeneous growth of the layers of semiconductor material. Leveling layer 26 covers all surface defects or irregularities that exist on the deposition surface of substrate 11 so that semiconductor material 27 is deposited upon a substantially level surface free of the thousands of proturberances, sharp edges and craters normally associated with a substrate surface. The result is a marked decrease in the number of short circuit paths between the electrodes and a marked improvement in the homogeniety of the semiconductor material.

- 7 -

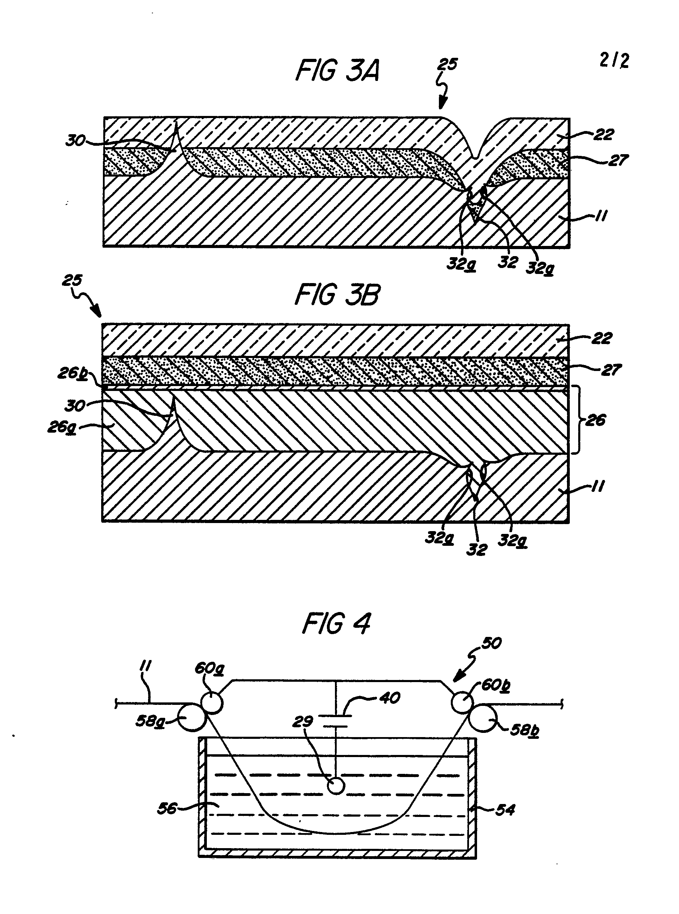

The formation and effect of surface defects is illustrated in Figure 3A which depicts a photovoltaic device 25 not provided with a leveling layer according to the invention. The device includes a substrate electrode 11, a body of semiconductor material 27 and a second electrode 22. A first defect region is depicted by a raised protruberance or spike 30 extending from the deposition surface of substrate 11. Protruberance 30 may result from, inter alia, metallurgical irregularities such as impurities, inclusions, columnar growth, etc. in the material from which substrate electrode 11 is formed, mechanical damage due to scratches or abrasions occuring during handling of substrate electrode 11, or particles of dust or other particulate matter contaminating the surface of substrate electrode 11 during handling and processing. Protruberance 30 is either incompletely or inadequately covered by the subsequently deposited layers of semiconductor material 27 or forms a nucleation center that promotes the nonhomogeneous deposition of that semiconductor material. A defect region is formed in the immediate vicinity of protuburance 30.

A second defect region is formed in the immediate vicinity of a crater 32. "Craters" are defined here as depressions in substrate 11 that include one or more sharp features. Such craters 32, which may also be referred to as pin holes or pits, may be formed by metallurgical or chemical irregularities in the surface the substrate electrode 11, or mechanical damage due to scratches or abrasions, occurring during handling of substrate 11. The variation in thickness of semiconductor material body 22 deposited on crater 32 results in a low resistivity current path between electrodes 11 and 22. Any sharply defined features 32a of crater 32 may form nucleating centers promoting the deposition of nonhomogeneous semiconductor layers.

Leveling layer 26 of the invention substantially prevents the formation of latent or patent low resistance current paths through semiconductor layers, drastically reducing the number of operational mode failures while improving the yield under room light of operational segments. In tests conducted with 288 tandem amorphous silicon p-i-n solar cells, which had the leveling layer of the instant invention deposited on their stainless steel substrates, no operational mode failures have been found after 346 hours of illumination. Further, room-light yields of the cells have approached 100 percent, indicating a substantial reduction in current-shunting defects which are caused by irregularities in the deposition surface of the substrate.

In Figure 3B, leveling layer 26 is shown disposed between body 27 of semiconductor material and the substrate electrode 11. The deposition surface of substrate electrode 11 includes surface defects such as sharply featured protruberance 30 and sharply featured crater 32.

In order to accomplish a leveling function, it is necessary that the leveling material (nickel in the preferred embodiment) be deposited on deposition surface of the electrically conductive substrate (stainless steel, mild steel, or aluminum in the preferred) 11 to a thickness that is great enough to cover the tallest protuberance rising above the surface of the substrate material. It has been determined that at least a 5 micrometer thick and, preferably, a 12 micrometer thick deposit of a nickel alloy plating material is sufficient to smooth the deposition surface of substrate 11 to form a substantially defect-free surface. It should be noted that following the deposition of the, for instance, nickel alloy plating layer 26a, a thin compatibility layer 26b is deposited on layer 26a to protect the surface finish of the nickel leveling layer, and render the deposition surface compatible (adhesive) with the subsequently deposited semiconductor layers. While it is preferred that the leveling layer be formed of a nickel alloy, it may also be formed of silver, indium, tin, cadmium, zinc and alloys of those metals.

Figure 4 depicts one station 50 of a plating apparatus that may include several such stations for continuously electroplating a leveling layer onto the elongated web of substrate material 11. Station 50 includes a tank 54 containing a bath of nickel alloy plating solution 56. The elongated web of substrate material 11 is continuously guided through the plating solution 56 by a pair of guide rollers 58a and 58b, although other guide means such as magnets and the like could serve the same function. Electrical contact is made with the deposition surface of the web 46 by rollers 60a and 60b, which are electrically connected to a power source, such as battery 40. The electrical circuit is completed by means of an electrode 29 immersed in plating solution 56. The composition of bath 56, the quantity and polarity of the plating current, and the composition of electrode 29 is dependent upon the material being plated onto the substrate electrode.

Plating solution 56 includes a minor quantity of an additive that inhibits plating of those portions of the deposition surface of substrate electrode 11 that exhibit the highest current density prior to the plating. The sharply defined features 32$\underline{a}$ of crater 32 or the jagged or pointed tips of protuberances 30 exhibit higher current densities than the more uniformly curved defects. Accordingly, the sharply defined features are first plated. The plating additive lowers the current density at these sharply defined features, to prevent excessive plating from occurring at the defects to provide a substantially level layer of the nickel alloy covering the surface defects. The most sharply defined defects, those most likely to cause semiconductor growth problems by forming nucleation centers, are rounded by the plating, if not totally covered. The result is a substantially defect-free deposition surface on which homogeneous semiconductor material may subsequently be deposited.

Example

Nickel was electroplated to a preselected thickness of twelve micrometers over the entire deposition surface of an elongated web of bright-annealed stainless steel (430 alloy) substrate in accordance with the following procedure. Cleansing was accomplished by first moving the web of substrate material through a mild detergent solution having a pH of approximately 8. After three minutes of immersion in the detergent solution, the web was guided through a bath of deionized cold water to rinse. The web was then soaked in a hydrochloric acid bath (50 percent by volume concentrated hydrochloric acid) at room temperature, after which the web was again subjected to a cold water rinse. The web was passed through a further bath containing one pound per gallon of Isoprep 192 (20 percent by volume concentrated hydrochloric acid plus 0.04 grams per liter of ammonium bifluoride). A cold water rinse then followed. This was followed by a one minute immersion in a room temperature bath of 100 grams per liter of sulfamic acid. Electrical contact was then made to the deposition surface of the web by utilizing an electrically conductive guide roller for providing a current of 3.7 amperes per square meter of web. The web of substrate material was then immersed, for three minutes, in a nickel alloy plate no. 829 plating bath at a current of 6.5 amperes per square meter of web. The nickel alloy plate no. 829 bath is a commercially available product supplied by the Allied-Kelite Division of the Witco Chemical Company. After a cold water rinse, the web was passed through a nickel sulfamate bath for 10 seconds followed by a cold water rinse. The web was then dipped into a room temperature bath of Isoprep 192 followed by another cold water rinse. Finally, the web moved through a chrome plate bath for three minutes at a current of 186 amperes per square meter. The electroplated nickel alloy layer thus deposited onto the stainless steel substrate was homogeneous, and exhibited good adhesion, a smooth, level surface.

It should be noted that the additives found in the nickel plate no. 829 bath operate to retard the deposition of the nickel alloy leveling material at those defect sites of the highest current densities, such as the tips of protuberances that rise above the deposition surface of the electrically conductive substrate and the sharply defined features of craters that fall below the deposition surface of the electrically conductive substrate. The result is the deposition of a nickel alloy leveling layer upon which level, uniform, homogeneous thin film layers of high quality amorphous semiconductor material may be deposited.

While the foregoing example describes the use of a nickel alloy plating bath, other plating baths of electrically-conductive alloys could also be employed in a similar manner for electroplating those conductive alloys onto the deposition surface of either a stainless steel or aluminum substrate. The only requirement is that the deposited material provide a smooth, level substrate which is substantially free of surface defects and compatible with the subsequently deposited semiconductor material.

CLAIMS

1. An improved semiconductor device comprising:

an electrically conductive substrate (11) having a deposition surface including at least one defect (30) capable of providing a low resistance current path through subsequently deposited semiconductor material or a nucleation center (32) promoting the deposition of nonhomogeneous semiconductor material; and a thin film body (27) of semiconductor material deposited on said substrate, characterized in that a relatively thick, continuous, electrically conductive electroplated leveling layer (26) is interposed between said deposition surface and said body (27).

2. The device of claim 1 characterized in that the leveling layer is formed primarily from a material chosen from the group consisting essentially of nickel, silver, indium, tin, cadmium, zinc, and mixtures thereof.

3. The device of claim 1 characterized in that the leveling layer (26) forms a first electrode of the semiconductor device.

4. The device of claim 1 characterized in that said leveling layer has a thickness of at least 5 micrometers.

5. The device of claim 1 characterized in that said substrate (11) is formed of stainless steel and the leveling layer (26) is formed of a nickel alloy.

6. A method of fabricating an improved, semiconductor device, said device including an electrically conductive substrate (11) having a deposition surface, including at least one surface defect (30) capable of providing a low resistance current path through the subsequently deposited semiconductor material or a nucleation center (32) which promotes the deposition of nonhomogeneous semiconductor material characterized in:

electroplating a relatively thick, continuous electrically conductive leveling layer (26) on the deposition surface of the substrate (11); and

depositing a thin film body (27) of homogeneous semiconductor material on said leveling layer (26).

7. The method of claim 6 characterized in selecting the material of leveling layer from the group consisting essentially of nickel, silver, indium, tin, cadmium, zinc, and mixtures thereof.

8. The method of claim 6 characterized in forming the leveling layer in an electroplating bath that includes minor quantities of an additive that retards the rate of leveling layer deposition at those regions on said deposition surface that exhibit the highest current density.

9. The method of claim 6 characterized in depositing the leveling layer to a thickness of at least 5 micrometers.

10. The method of claim 6 characterized in electroplating a nickel alloy leveling layer on a stainless steel substrate.

FIG 1

FIG 2

0155125

2/2

FIG 3A

FIG 3B

FIG 4